(19) **Europäisches Patentamt / European Patent Office / Office européen des brevets**

(11) **EP 1 764 828 A1**

(12) **DEMANDE DE BREVET EUROPEEN**

(43) Date de publication:
**21.03.2007 Bulletin 2007/12**

(51) Int Cl.:
**H01L 21/60** *(2006.01)*

(21) Numéro de dépôt: **06300820.5**

(22) Date de dépôt: **20.07.2006**

(84) Etats contractants désignés:
**AT BE BG CH CY CZ DE DK EE ES FI FR GB GR HU IE IS IT LI LT LU LV MC NL PL PT RO SE SI SK TR**
Etats d'extension désignés:
**AL BA HR MK YU**

(30) Priorité: **30.08.2005 FR 0552613**

(71) Demandeur: **COMMISSARIAT A L'ENERGIE ATOMIQUE**
**75015 Paris (FR)**

(72) Inventeur: **Marion, François**
**38950, Saint Martin Le Vinoux (FR)**

(74) Mandataire: **Vuillermoz, Bruno et al**
**Cabinet Laurent & Charras**
**B.P. 32**
**20, rue Louis Chirpaz**
**69134 Ecully Cédex (FR)**

(54) **Procédé d'hybridation par protubérances de soudure de tailles différentes de deux composants entre eux et dispositif mettant en oeuvre deux composants hybrides entre eux selon ce procédé**

(57) Ce procédé d'hybridation consiste :
- à munir un premier composant **1** de premiers plots **3** de réception de protubérances,
- à munir un deuxième composant **2** de deuxièmes plots **5** de réception de protubérances,
- les premiers **3** et deuxièmes **5** plots étant respectivement destinés à être associés deux à deux pour former des paires de plots,
- puis, à munir les premiers plots et/ou les deuxièmes plots de protubérances **4** réalisées en un matériau fusible,
- puis à reporter l'un sur l'autre les premier et deuxième composants,

- puis à porter l'ensemble des premier et deuxième composants et corollairement les protubérances de soudure à une température de soudure pour interconnecter les premiers et deuxièmes plots de chaque paire de plots par soudage des protubérances sur ces plots,
- et enfin, à faire refroidir la soudure ainsi obtenue.

Parmi les protubérances **4** de matériau fusible équipant les premiers **3** et/ou les deuxièmes **5** plots, sont réalisées au moins trois protubérances **6** de plus grandes dimensions, et notamment de plus grande hauteur, de telle sorte qu'avant élévation de la température jusqu'à atteindre la température d'hybridation, le composant reporté ne repose limitativement que sur ces protubérances.

**Fig. 3a**

L=(N-1)*pas

**(Cont. page suivante)**

EP 1 764 828 A1

Fig. 3b

Fig. 3c

**Description**

**DOMAINE DE L'INVENTION**

La présente invention concerne le domaine de la microélectronique et plus particulièrement celui des techniques d'hybridation par billes de composants hétérogènes. Elle s'applique plus particulièrement à la réalisation de dispositifs de détection de rayonnements électromagnétiques du type matriciel de grande taille. Parmi ceux-ci, les matrices de détection de rayons X ou de rayonnements infrarouges sont principalement visées.

Au sens de la présente invention, on entend par "composant", aussi bien un composant électronique, tel qu'une puce électronique, un support de circuit électronique ou optoélectronique, qu'un composant mécanique du type capot de protection ou un capteur de grandeurs physiques.

**ETAT ANTERIEUR DE LA TECHNIQUE**

La technique d'hybridation visée par la présente invention est limitée à l'hybridation par fusion. Cette technique, aujourd'hui largement connue, met en oeuvre des billes réalisées en un matériau fusible, tel que par exemple en un alliage étain - plomb, étain — indium, voir même constitué d'indium pur.

Succinctement, cette technique d'hybridation par fusion consiste :

- à déposer sur des plots réalisés sur l'un des composants, des billes de matériau fusible, lesdits plots étant constitués d'un matériau mouillable par le matériau constitutif des billes de soudure ;
- puis à munir l'autre composant à hybrider de plots constitués également en un matériau mouillable par le matériau constitutif des billes de soudure, lesdits plots étant ménagés sensiblement à l'aplomb des plots dudit premier composant lorsque ledit second composant est reporté sur le premier ;
- puis, par élévation de la température jusqu'à atteindre une température supérieure à la température de fusion du matériau constitutif les billes, à obtenir la fusion de celles-ci jusqu'à aboutir au résultat recherché, à savoir l'hybridation du second composant sur le premier composant, lesdites billes créant un lien mécanique et/ou électrique entre les plots de chacun des composants.

Pour les composants de relativement faibles dimensions, la précision du positionnement mutuel desdits composants lors du report du composant supérieur sur le composant inférieur, n'est pas très critique. En effet, les phénomènes de tension superficielle affectant les billes d'hybridation lors de l'opération de fusion, induisent un alignement automatique desdits composants. Au surplus, ces mêmes phénomènes de tension superficielle permettent d'absorber, à tout le moins en partie, les phénomènes de dilatation thermique affectant les deux composants, de coefficient de dilatation thermique différents, et se traduisant par le déplacement relatif des plots de l'un des composants par rapport à l'autre.

Pour les composants de plus grandes dimensions, une solution technique connue liée au problème de dilatation différentielle des composants, consiste à compenser les phénomènes de dilatation en intervenant au niveau de la conception même des composants.

Ainsi, dans le document FR 2 748 849, on a proposé de déplacer les surfaces de mouillabilité du composant à hybrider selon une homothétie linéaire afin qu'à la température d'hybridation, lesdites surfaces de mouillabilité se retrouvent sensiblement à l'aplomb et de manière non décalée des surfaces de mouillabilité ou plots de l'autre composant, absorbant ce faisant, la dilatation différentielle.

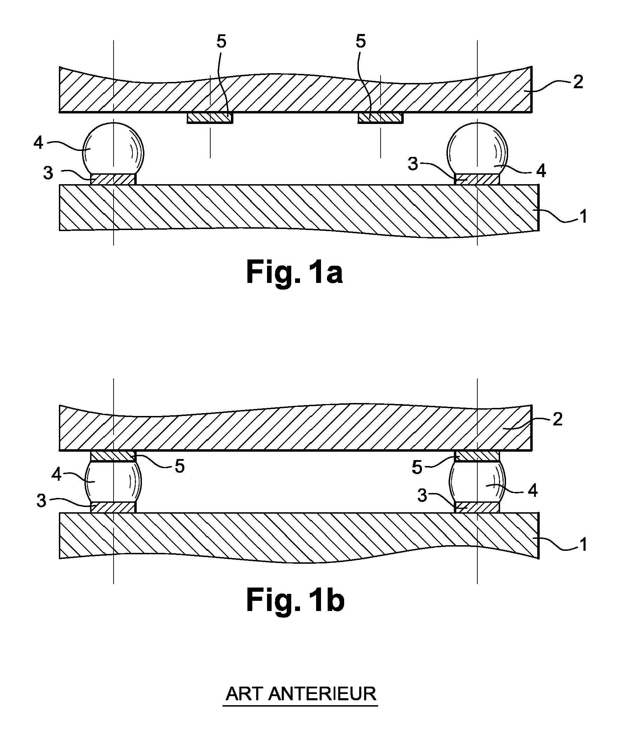

On a de fait représenté schématiquement en relation avec les figures 1a et 1b, le principe sous-tendant la solution technique retenue par ce document, la figure 1a représentant une coupe schématique avant hybridation d'un système de composants à hybrider à la température ambiante, et la figure 1b étant une vue analogue à la figure 1a, mais à la température d'hybridation des composants.

Ainsi, selon ces figures 1a et 1b, la référence **1** désigne le substrat, par exemple réalisé en silicium, la référence **2** désigne le capot, destiné à être rapporté sur ce substrat. Le substrat **1** est muni de zones de mouillabilité **3,** typiquement réalisées en or, avec barrière préalable à base d'un alliage de titane ou de nickel, et sur lesquelles ont été déposées des billes d'hybridation **4.** De la même manière, ont été réalisées, sur la face inférieure du capot **2,** des surfaces de mouillabilité **5,** mais exemptes de billes d'hybridation. Selon les enseignements de ce document, à température ambiante, les surfaces de mouillabilité **5** du capot **2** ne sont pas situées à l'aplomb des surfaces de mouillabilité **3** du substrat **1** lorsque ledit capot est reporté sur ledit substrat.

En revanche, en raison des différence de coefficients de dilatation thermique, respectivement du substrat $\alpha 1$ et du capot $\alpha 2,$ lorsque l'on atteint la température d'hybridation, supérieure à la température de fusion du matériau constitutif des billes **4,** on observe une migration des surfaces de mouillabilité **5** dudit capot, telles qu'elles viennent se positionner sensiblement à l'aplomb des surfaces de mouillabilité **3** du substrat **1,** de sorte que l'hybridation est possible telle que matérialisée sur la figure 1b.

Si cependant, le procédé décrit dans ce document fonctionne de manière satisfaisante pour des matrices de tailles relativement réduites, notamment inférieures à 1000 x 1000 pixels, en revanche dès lors que les matrices sont de dimensions supérieures, on se heurte à un certain nombre de problèmes techniques.

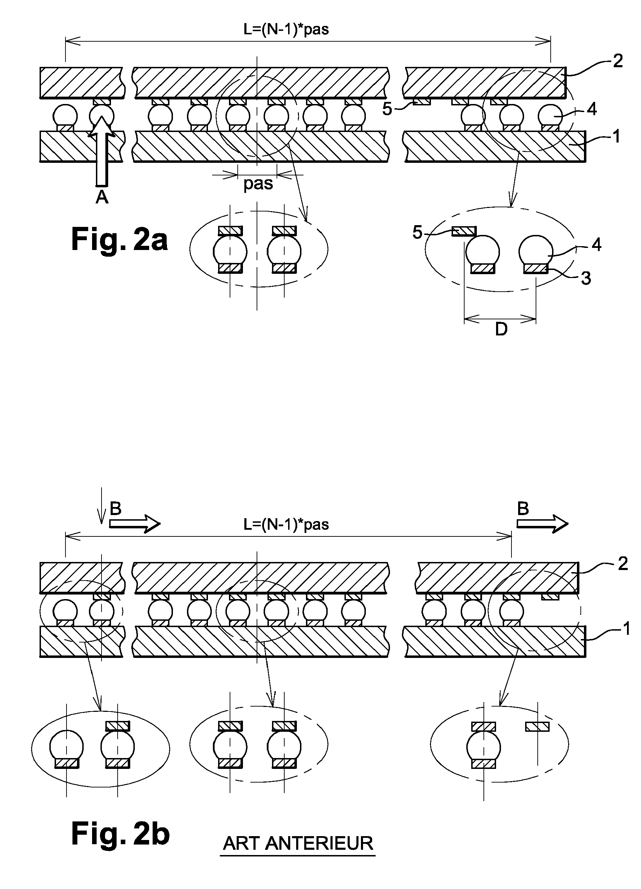

Tout d'abord, la conception des composants selon ce document repose sur le principe du décalage des surfaces de mouillabilité en raison des dilatations thermiques, sensiblement uniformes par rapport à un barycentre. Malheureusement, en raison des contraintes liées à la réalisation proprement dite de ces composants, l'obtention de surfaces parfaites et régulières, et notamment de celles destinées à venir en regard des composants en question, est un idéal difficilement obtenu, de sorte qu'il se créé fréquemment ce que la technique qualifie de points fixes de glissement ou points d'accroche, illustré par la flèche **A** sur la figure 2a. Ce faisant, en raison de ces points d'accroche, la dilatation thermique, notamment du capot dans l'exemple décrit, va s'effectuer à partir de celui-ci, et non pas à partir d'un point sensiblement central de la matrice, et engendre un décalage important au niveau des surfaces de mouillabilité les plus éloignées de ce point d'accroche, illustré par la flèche **B** sur la figure 2a.

En effet, si **L** désigne la distance séparant les deux zones de mouillabilité les plus extrêmes du substrat, et que sur cette longueur celui-ci comporte **N** pixels, alors on peut écrire la relation L = (N-1) x pas, le pas étant communément défini comme la distance séparant deux pixels consécutifs.

Corollairement, si **D** désigne le décalage entre une bille ou une zone de mouillabilité du substrat **1** et la zone de mouillabilité avec laquelle elle est destinée à coopérer au niveau du capot **2**, on peut écrire la relation suivante :

$$D = (\alpha 2 - \alpha 1) \times (Th - Ta) \times L/2 = (\alpha 2 - \alpha 1) \times (Th - Ta) \times (N - 1)/2 \times pas$$

et ce, conformément aux enseignement du document précité, avec Th : température d'hybridation et Ta : Température ambiante.

Ainsi, à titre exemplatif, pour une matrice de tellure de cadmium CdTe de 4000 x 4000 points hybridée sur du silicium au pas de $10\mu m$ et de taille de 40 x 40 cm, avec une variation de coefficients de dilatation thermique $\alpha 2 - \alpha 1$ de l'ordre de $3 \times 10^{-6}$, la dilatation différentielle **D** pour un écart de température de 170°C, est égal à 1,2 pas.

En d'autres termes, lors du dépôt des puces, l'avant-dernière bille **N-1** de la périphérie de la puce inférieure, en l'espèce du substrat **1**, est située en regard de la surface de mouillabilité **N** de la puce supérieure **2**. Cette compensation de dilatation conduit à un décalage égal à 1 pixel, tel qu'illustré sur la figure 2b (voir sur la droite). Outre les dilatations linéaires, la pratique démontre l'existence de dilatations rationnelles ou circulaires, voire d'autres types de mouvement.

En d'autres termes, le problème technique qu'entend solutionner la présente invention réside dans le fait que le barycentre de la dilatation n'est pas maîtrisé en raison de l'existence de points d'accroche créés par les topologies des technologies. C'est le point le plus en saillie des surfaces en contact qui peut constituer le centre de dilatation, et ainsi perturber l'hybridation des composants. Si pour les composants de faibles tailles, le problème est limité du fait que les décalages restent inférieurs à la valeur du pas, en revanche, pour les composants de tailles plus importantes, le défaut peut impacter sensiblement les rendements de fabrication.

## EXPOSE DE L'INVENTION

La présente invention vise donc à surmonter cet inconvénient, notamment pour des composants de dimensions plus importantes. Globalement, elle vise à positionner en quelque sorte des cales, en milieu de composants, pour ne pas affecter les éléments de soudure proprement dits, notamment avant hybridation. Selon l'invention, les cales et les éléments de soudure peuvent présenter des formes variées. Ils sont seront indifféremment appelés par la suite « billes » sans pour autant que ce terme implique nécessairement une forme sphérique.

Plus précisément, l'invention vise un procédé d'hybridation par protubérances de soudure d'un premier composant avec un deuxième composant consistant :

- à munir le premier composant de premiers plots de réception de protubérances, ledit premier composant présentant un premier coefficient de dilatation thermique,
- à munir le deuxième composant de deuxièmes plots de réception de protubérances, ledit deuxième composant présentant un deuxième coefficient de dilatation thermique,
- les premiers et deuxièmes plots étant respectivement destinés à être associés deux à deux pour former des paires de plots et, les premiers et deuxièmes plots étant réalisés sur les premier et deuxième composants en des emplacements tels que :

  • à la température d'hybridation Th, les premiers et deuxièmes plots de chaque paire de plots sont sensiblement superposables, et

- à la température ambiante Ta, les plots de chaque paire de plots sont mutuellement décalés d'une distance de compensation d'une dilatation différentielle des premier et deuxième composants entre les températures ambiante Ta et d'hybridation Th,

- puis, à munir les premiers plots et/ou les deuxièmes plots de protubérances réalisées en un matériau fusible,
- puis à reporter l'un sur l'autre les premier et deuxième composants,
- puis à porter l'ensemble des premier et deuxième composants et corollairement les protubérances de soudure à une température de soudure Th pour interconnecter les premiers et deuxièmes plots de chaque paire de plots par soudage des protubérances sur ces plots,
- et enfin, à faire refroidir la soudure ainsi obtenue.

Selon l'invention, parmi les billes ou protubérances de matériau fusible équipant les premiers et/ou les deuxièmes plots, sont réalisées au moins trois billes de plus grandes dimensions, et notamment de plus grande hauteur, de telle sorte qu'avant élévation de la température jusqu'à atteindre la température d'hybridation Th, le composant reporté ne repose limitativement que sur ces billes.

En outre, ces billes de grandes dimensions dites "billes de calage" sont positionnées sensiblement au centre desdits premier et/ou deuxième composants.

Ce faisant, le barycentre de dilatation est imposé au centre de la puce hybridée par cette zone de contact limitée.

Comme on l'aura compris, ces billes particulières, au moins au nombre de trois afin d'assurer effectivement l'élévation du composant à reporter par rapport au reste des autres billes, font fonction de cales, propres à permettre la dilatation des deux composants l'un par rapport à l'autre sans point d'accroche particulier. Et ce n'est qu'au moment voulu que les composants en question sont assemblés lorsque toutes les billes de soudure ont atteint la température de fusion.

Ce faisant, ces billes de plus grandes dimensions maintiennent le composant à reporter à une distance telle que les autres billes ne sont pas en contact avec les plages d'accueil ou surfaces de mouillabilité avant assemblage, de sorte qu'il ne peut y avoir de soudure intempestive en raison des défauts de conception ou de planéité desdits composants.

Bien évidemment, la mise en oeuvre de l'invention ne doit pas modifier les caractéristiques du composant à hybrider. Ainsi, les pixels doivent rester selon un pas déterminé et l'invention vise donc à introduire, en respectant ce pas, au moins trois billes plus hautes que les autres.

De manière connue, une bille est définie d'une part, par sa surface inférieure d'accroche, d'autre part, par sa surface supérieure d'accroche, et enfin par le volume de matériau de soudure mis en jeu.

Il résulte de ces paramètres deux autres données à prendre en considération, respectivement la hauteur de bille avant hybridation et la hauteur de bille après hybridation.

Selon l'invention, on cherche à réaliser les billes les plus grosses possibles dans un pas donné. En effet, une telle configuration permet de rattraper d'autant plus les défauts de planéité éventuels entre les deux composants à hybrider. Néanmoins, la mise en oeuvre de l'invention se heurte à la difficulté suivante en fonction des valeurs respectives du pas d'interconnexion et de la hauteur des billes requise.

Ainsi et selon une première caractéristique de l'invention, si le pas d'interconnexion est supérieur à deux fois la hauteur de billes, l'invention telle que définie précédemment s'applique sans difficulté. A cet égard, il est rappelé que la hauteur de billes est imposée par les règles de fiabilité, les différences de planéités des composants à hybrider et la technologie de réalisation de billes.

Dans ce cas là, deux types de billes sont nécessaires, respectivement :

- des billes hautes au centre de la matrice, et on l'a vu au moins trois pour supporter le composant à hybrider,
- des billes basses partout ailleurs dans la matrice.

Selon cette configuration, la hauteur des billes hautes avant hybridation est supérieure à celles des billes dites "billes basses". En revanche, la hauteur des billes hautes ou des billes basses après hybridation est sensiblement la même.

En revanche, lorsque le pas d'interconnexion est inférieur à deux fois la hauteur des billes hautes, celles-ci occupent alors quasiment tout l'espace alloué dans le pas. L'invention consiste à devoir mettre en oeuvre trois types de billes, avec un agencement particulier entre celles-ci.

Des billes hautes au centre, entrelacées ou alternées avec des billes basses, et des billes intermédiaires, c'est à dire de hauteur intermédiaire partout ailleurs. L'entrelacement entre les billes hautes et les billes basses, de hauteur inférieure au pas, permet de tenir compte des limitations technologiques qui se posent au centre des composants à hybrider, dans la mesure où l'on doit conserver le pas d'interconnexion.

Ainsi, en insérant ou en alternant des billes hautes de taille supérieure au pas d'interconnexion et des billes basses jouxtant les billes hautes, et présentant une taille inférieure audit pas, il devient possible de respecter ce dernier.

Cette alternance ou cette interconnexion permet de satisfaire les deux règles fondamentales d'hybridation, à savoir :

- une hauteur globale d'hybridation la plus élevée possible, ce qui facilité le nettoyage après hybridation ; ce nettoyage est destiné à éliminer les résidus laissés par le fluide de brasage, souvent un liquide gras ; ce nettoyage est par exemple réalisé par jets d'eau ;
- un volume du pixel occupé par la soudure le plus grand possible, ce qui permet d'augmenter les tolérances de différences de planéité entre les composants à hybrider.

## BREVE DESCRIPTION DES DESSINS

La manière dont l'invention peut être réalisée et les avantages qui en découlent ressortiront mieux des exemples de réalisation qui suivent, donnés à titre indicatif et non limitatif à l'appui des figures annexées.

Comme déjà dit, les figures 1a à 2b représentent des vues schématiques en section des technologies de l'art antérieur.

Les figures 3a, 3b et 3c représentent des vues analogues illustrant le principe général sous-tendant l'invention.

La figure 4 est une vue analogue aux figures précédentes, représentant le cas particulier où le pas d'interconnexion est inférieur à deux fois la hauteur des billes dites « hautes », dont la figure 5 est une vue de dessus du composant inférieur.

La figure 6 est une représentation schématique d'un mode de réalisation des billes.

## DESCRIPTION DETAILLEE DE L'INVENTION

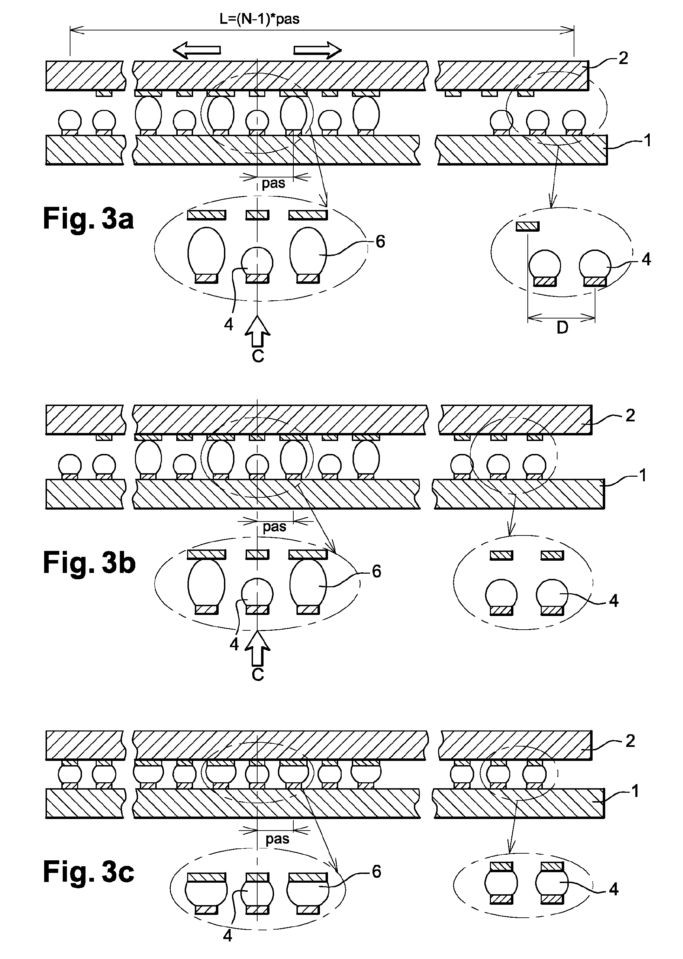

On a donc représenté en relation avec les figures 3a, 3b, 3c le principe général illustrant la présente invention, et correspondant respectivement à la température ambiante, à une température proche de la température de soudure après glissement et dilatation, et enfin aux positionnements respectifs des composants pendant l'hybridation, donc à une température supérieure à la température de fusion du matériau constitutif des billes.

Par rapport à la description déjà réalisée des figures de l'art antérieur, on observe la présence d'un certain nombre de billes dites "hautes" **6**, c'est-à-dire dont la hauteur à température ambiante est nettement supérieure à celle des autres billes d'interconnexion proprement dite **4** et d'hybridation, dites aussi billes basses. Ce faisant les volumes respectifs sont également différents.

A température ambiante, on peut observer le décalage des zones de mouillabilité ou des surfaces d'accroche **5** du composant supérieur, et en l'espèce du capot **2** par rapport aux billes avec lesquelles elles sont destinées à coopérer. Bien évidemment, il n'est pas décrit ici le mode de réalisation des surfaces de mouillabilité, ni le mode de dépôt des billes en question, attendu que ces technologies sont parfaitement maîtrisées par l'homme du métier.

Cependant, on pourra néanmoins utilement se référer aux autres demandes de brevets déposées le même jour par le Demandeur, mettant en oeuvre des perfectionnements particuliers de ces technologies.

Selon l'invention, le nombre de billes hautes **6** est d'au moins trois et, avantageusement positionnées au centre des composants à hybrider. Ce faisant, on impose comme point d'origine des effets de dilatation le centre de la puce hybridée. On observe donc, à température ambiante, que le composant à hybrider, le capot en l'espèce, ne repose que sur ces seules billes hautes **6**.

Dans la figure suivante (figure 3b), le phénomène de dilatation est intervenu et l'on observe le positionnement des zones de mouillabilité ou zones d'accroche **5** du composant supérieur ou capot **2**, sensiblement à l'aplomb des billes **4** avec lesquelles elles sont destinées à coopérer. La fusion n'est cependant pas encore intervenue, celle-ci étant représentée en relation avec la figure 3c. Le phénomène de fusion se traduit par un affaissement du composant supérieur **2** en direction du composant **1** et corollairement par la mise en contact simultané des zones de mouillabilité **5** avec les billes d'hybridation **4**. A cet égard, et afin d'aboutir à cette hybridation optimisée, le choix de la surface d'accroche, notamment supérieure ou zone de mouillabilité des billes hautes, est important.

Dans le cas particulier où le pas des pixels est petit, typiquement inférieur à $15\mu m$, pas fréquemment rencontré pour des applications à des matrices de détection de rayonnements infrarouges, on se heurte à la difficulté d'insérer des billes hautes dans un tel pas, et respectant les préconisations de la présente invention.

En conséquence, dans la zone où se trouvent les cales **6** (billes hautes), les billes d'interconnexion n'ont plus de place : elles sont alors réalisées selon une taille plus petite **7**. Ce troisième type de billes, dites billes très basses, présente donc une taille inférieure aux deux autres. Ces billes présentent donc des volumes différents. En revanche, ces trois types de billes sont répartis selon le même pas : tous les centres des billes sont alignés.

Cependant, les technologies classiques de réalisation des billes ne sont pas facilement compatibles avec la réalisation de telles billes particulières, et notamment de l'alternance billes hautes — billes basses.

Aussi, fait on appel, dans le cas d'espèce, à un procédé particulier qui consiste à mettre en oeuvre une technique d'emboutissage d'une couche de matériau de fusion ou de soudure, et notamment d'un matériau ductile, le cas échéant conducteur d'électricité, préalablement déposée sur le substrat **1**.

Plus spécifiquement, cette couche est déposée sur une couche métallique de mouillabilité **14**, typiquement réalisée en or, elle-même déposée sur une couche métallique **13**, faisant fonction de barrière, et par exemple réalisée en un alliage à base de nickel.

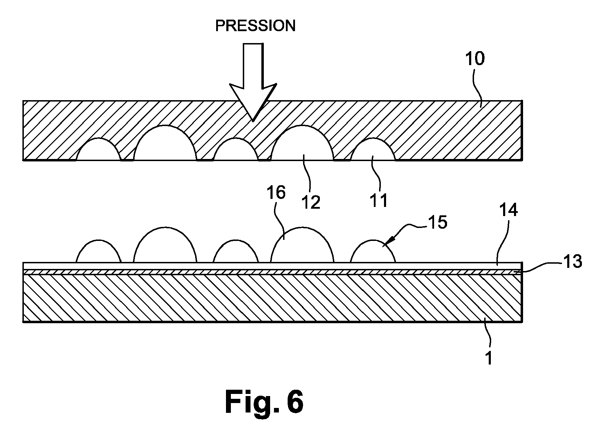

L'emboutissage de la couche en matériau ductile est réalisé au moyen d'une matrice **10** gravée, par exemple réalisée en silicium, et définissant des formes **11, 12** fonction de la forme que l'on souhaite conférer aux billes **15, 16**. On a schématiquement représenté ce principe de réalisation des billes en relation avec la figure 6. Cette technologie particulière fait l'objet d'une demande de brevet déposée le même jour par le Demandeur.

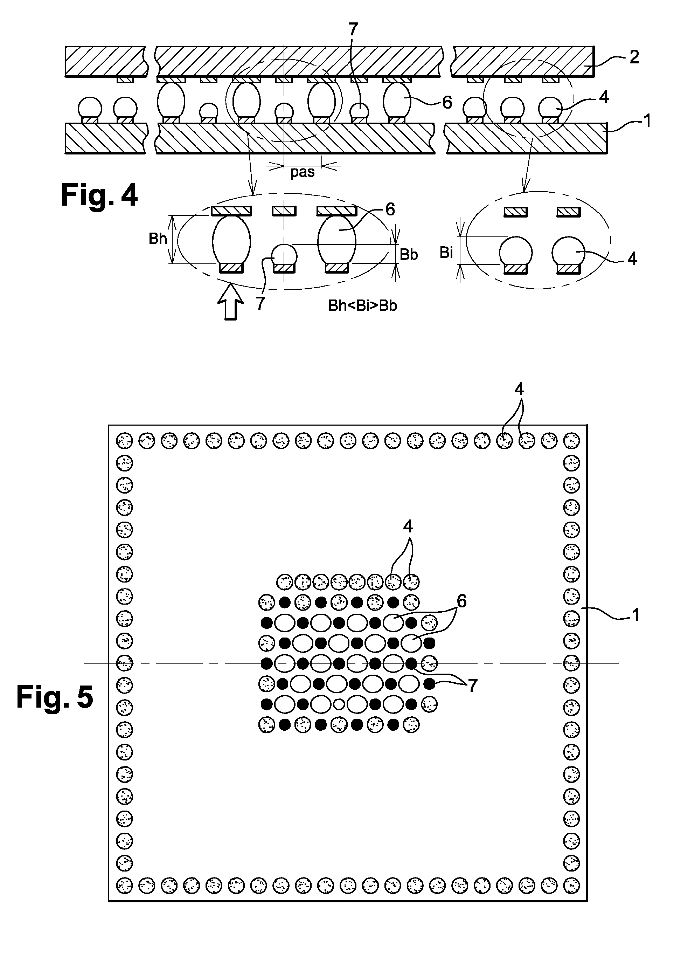

La gravure réalisée au sein de la matrice **10** permet notamment d'obtenir de manière aisée l'alternance de billes hautes et billes basses, conformément au schéma de la figure 5, ce que les technologies connues à ce jour ne permettent pas d'obtenir de manière simple et peu coûteuse.

Les billes obtenues après matriçage sont mises en forme par refusion, c'est à dire par élévation de température, supérieure ou égale à la température de fusion du matériau ductile.

Toujours selon cette forme de réalisation particulière, les autres billes sont des billes intermédiaires du type de celles décrites en relation avec les figures précédentes.

A titre d'exemple, dans le cas particulier de pas de pixel inférieur à 15$\mu$m, on réalise une zone centrale de 400 x 400 pixels au centre de la matrice. Dans cette hypothèse, et avec les données numériques de base indiquées en préambule, le déplacement respectif maximal des barycentres de dilatation durant la montée en température est alors limité à :

$$D = 3.10^{-6} \text{ x } 170 \text{ x } 200 \text{ x pas} = 1{,}5 \text{ } \mu\text{m}$$

De fait, à la température de fusion, les surfaces en regard sont au maximum décalées de 1,5 $\mu$m, il ne peut donc plus se produire de phénomènes de décalage observé avec les technologies de l'art antérieur.

Ce faisant, le procédé de l'invention trouve différentes applications, notamment dans la réalisation de matrices et autres barrettes de détection de rayons X de très grandes tailles, particulièrement appréciées dans le domaine médical, ainsi que dans la réalisation de matrices et autres barrettes de détection de rayonnements infrarouges également de très grandes tailles, et de manière générale, dès lors qu'est mise en oeuvre une hybridation pour composants de grandes tailles, qu'il s'agisse de barrettes ou de matrices.

**Revendications**

1. Procédé d'hybridation par protubérances ou billes de soudure d'un premier composant **1** avec un deuxième composant **2** consistant :

    - à munir le premier composant **1** de premiers plots **3** de réception de protubérances, ledit premier composant **1** présentant un premier coefficient de dilatation thermique,
    - à munir le deuxième composant **2** de deuxièmes plots **5** de réception de protubérances, ledit deuxième composant **2** présentant un deuxième coefficient de dilatation thermique,
    - les premiers **3** et deuxièmes **5** plots étant respectivement destinés à être associés deux à deux pour former des paires de plots et, les premiers et deuxièmes plots étant réalisés sur les premier et deuxième composants en des emplacements tels que :

        • à la température d'hybridation Th, les premiers **3** et deuxièmes **5** plots de chaque paire de plots sont sensiblement superposables, et
        • à la température ambiante Ta, les plots de chaque paire de plots sont mutuellement décalés d'une distance de compensation d'une dilatation différentielle des premier et deuxième composants entre les températures ambiante Ta et d'hybridation Th,

    - puis, à munir les premiers plots et/ou les deuxièmes plots de protubérances **4** réalisées en un matériau fusible,
    - puis à reporter l'un sur l'autre les premier et deuxième composants,
    - puis à porter l'ensemble des premier et deuxième composants et corollairement les protubérances de soudure à une température de soudure Th pour interconnecter les premiers et deuxièmes plots de chaque paire de plots par soudage des protubérances sur ces plots,
- et enfin, à faire refroidir la soudure ainsi obtenue,

*caractérisé :*

■ **en ce que** parmi les protubérances **4** de matériau fusible équipant les premiers **3** et/ou les deuxièmes **5** plots, sont réalisées au moins trois protubérances **6** de plus grandes dimensions, et notamment de plus grande hauteur, de telle sorte qu'avant élévation de la température jusqu'à atteindre la température d'hybridation Th, le composant reporté ne repose limitativement que sur ces protubérances,
■ et **en ce que** lesdites protubérances ou billes de grandes dimensions dites billes (ou protubérances) « de calage » ou billes (ou protubérances) « hautes » **6** sont positionnées sensiblement au centre desdits premier et/ou deuxième composants.

**2.** Procédé d'hybridation par protubérances de soudure selon la revendication 1, *caractérisé* **en ce que** la hauteur des billes (ou protubérances) hautes **6** avant hybridation est supérieure à celles des autres billes (ou protubérances) d'hybridation **4**, et **en ce que** la hauteur des billes hautes **6** et des autres billes **4** après hybridation sont sensiblement les mêmes.

**3.** Procédé d'hybridation par protubérances de soudure selon l'une des revendications 1 et 2, *caractérisé* **en ce que** la zone centrale de l'un des composants reçoit un entrelacement ou alternance de billes hautes **6** et de billes très basses **7**, et **en ce que** le reste dudit composant reçoit des billes dites basses **4**, la hauteur desdites billes très basses **7** étant inférieure à celle des billes basses **4**, et la hauteur de chacun des ces trois types de billes étant sensiblement identique après hybridation.

**4.** Dispositif comprenant deux composants hybridés l'un avec l'autre au moyen de protubérances de soudure par l'intermédiaire de plots de réception desdites protubérances, *caractérisé* **en ce que** les protubérances **4, 6, 7** présentent des volumes différents, les protubérances de grand volume **6** étant positionnées sensiblement au centre de l'un desdits composants.

**Fig. 1a**

**Fig. 1b**

ART ANTERIEUR

**Fig. 2a**

$L = (N-1) \cdot pas$

pas

A

D

**Fig. 2b**     ART ANTERIEUR

$L = (N-1) \cdot pas$

B     B

L=(N-1)*pas

**Fig. 3a**

pas

C

D

2

1

6

4

4

**Fig. 3b**

pas

C

2

1

6

4

4

**Fig. 3c**

pas

2

1

6

4

4

**Fig. 4**

Bh

Bb

Bi

Bh<Bi>Bb

pas

**Fig. 5**

PRESSION

10

16  12  11

15

14

13

1

**Fig. 6**

# EP 1 764 828 A1

**Office européen des brevets**

## RAPPORT DE RECHERCHE EUROPEENNE

Numéro de la demande

EP 06 30 0820

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | DE 41 01 042 C1 (MESSERSCHMITT-BOELKOW-BLOHM GMBH, 8012 OTTOBRUNN, DE) 20 février 1992 (1992-02-20) * figures 1,2 * ----- | 4 | INV. H01L21/60 |
| A | US 2003/197286 A1 (HILTON ROBERT M) 23 octobre 2003 (2003-10-23) * figures 5a,5b * ----- | | |
| D,A | FR 2 748 849 A (COMMISSARIAT A L'ENERGIE ATOMIQUE) 21 novembre 1997 (1997-11-21) * le document en entier * ----- | | |
| A | US 5 894 984 A (SAKAI ET AL) 20 avril 1999 (1999-04-20) * figures 7a-7c * ----- | | |

DOMAINES TECHNIQUES RECHERCHES (IPC)

H01L

Le présent rapport a été établi pour toutes les revendications

| Lieu de la recherche | Date d'achèvement de la recherche | Examinateur |
|---|---|---|
| La Haye | 1 février 2007 | Kästner, Martin |

CATEGORIE DES DOCUMENTS CITES

X : particulièrement pertinent à lui seul
Y : particulièrement pertinent en combinaison avec un
autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...............................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 06 30 0820

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

01-02-2007

| Document brevet cité au rapport de recherche | | Date de publication | Membre(s) de la famille de brevet(s) | | Date de publication |
|---|---|---|---|---|---|
| DE 4101042 | C1 | 20-02-1992 | AUCUN | | |
| US 2003197286 | A1 | 23-10-2003 | US | 2002109238 A1 | 15-08-2002 |
| FR 2748849 | A | 21-11-1997 | EP | 0818813 A1 | 14-01-1998 |
| | | | US | 6170155 B1 | 09-01-2001 |
| US 5894984 | A | 20-04-1999 | JP | 3296130 B2 | 24-06-2002 |
| | | | JP | 8288637 A | 01-11-1996 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2748849